Europäisches Patentamt

European Patent Office

Office européen des brevets

(19)

(11) Veröffentlichungsnummer: **0 103 879**
**A1**

(12) # EUROPÄISCHE PATENTANMELDUNG

(21) Anmeldenummer: 83109272.1

(22) Anmeldetag: 19.09.83

(51) Int. Cl.³: **H 01 L 21/90**
**H 01 L 23/52**

(30) Priorität: 21.09.82 DE 3234907

(43) Veröffentlichungstag der Anmeldung:
28.03.84 Patentblatt 84/13

(84) Benannte Vertragsstaaten:
AT DE FR GB IT

(71) Anmelder: SIEMENS AKTIENGESELLSCHAFT
Berlin und München Wittelsbacherplatz 2
D-8000 München 2(DE)

(72) Erfinder: Eggers, Harald, Dipl.-Ing.
Erich-Kästner-Strasse 19
D-8000 München 40(DE)

(72) Erfinder: Glasl, Andreas, Dipl.-Phys.
Otto-Hahn-Strasse 2
D-8013 Haar(DE)

(72) Erfinder: Kerschbaum, Manfred, Dipl.-Ing.
Nietzschestrasse 34 B
D-8000 München 40(DE)

(54) Verfahren zum Herstellen einer monolithisch integrierten Schaltung.

(57) Bei der Herstellung einer monolithisch integrierten Halbleiter-schaltung mit wenigstens zwei übereinander angeordneten Leitbahnebenen wird die jeweils zuletzt aufgebrachte strukturierte Metallisierung zunächst mit einer Polyimidschicht und letztere mit einer – durch Plasmaentladung erzeugten – Siliciumnitridschicht abgedeckt. Diese wird als Träger der neu aufzubringenden Leiterbahnebene verwendet. Auf diese Weise werden Unterbrechungen an den Überkreuzungsstellen von Leitbahnen, insbesondere aus Aluminium, vermieden. Außerdem wird das Haftvermögen im Vergleich zu unmittelbar auf einer Polyimidunterlage aufgebrachten Leiterbahnen verbessert.

**FIG 2**

EP 0 103 879 A1

Siemens Aktiengesellschaft
Berlin und München

Unser Zeichen
VPA 82 P 1 8 0 1 E

Verfahren zum Herstellen einer monolithisch integrierten Schaltung

Die Erfindung bezieht sich auf ein Verfahren zum Herstellen einer monolithisch integrierten Schaltung, bei dem die Oberfläche des zur Aufnahme der pn-Übergänge der integrierten Schaltung dienenden und vorzugsweise aus monokristallinem Silicium bestehenden Halbleitersubstrats mit einer $SiO_2$-Schicht versehen und letztere als Träger für eine durch Leitbahnen bzw. durch kapazitiv mit der Oberfläche des Halbleitersubstrats unter Vermittlung der $SiO_2$-Schicht gekoppelten Elektroden gegebene erste Metallisierung verwendet wird, bei dem nach Herstellung der ersten Metallisierung diese mit Isolierschichten abgedeckt und diese Isolierschichten nach deren Strukturierung als Träger für eine weitere zu Leitbahnen zu verarbeitende Metallisierung verwendet werden.

Solche Verfahren führen somit zu integrierten Halbleiterschaltungen mit sog. Zwei- oder Mehrlagenverdrahtung. Bei der Herstellung von integrierten Schaltungen mit Mehrlagenverdrahtung wird, wie der Erfahrungen der letzten Zeit zeigen, im zunehmenden Maße der Einsatz eines einebnenden Dielektrikums zwischen den benachbarten Metallisierungsebenen (=Verdrahtungslagen) erforderlich. Die sich immer mehr geltend machende Verkleinerung lateraler Strukturgrößen zeigt insbesondere bei Verwendung von mehr als zwei Verdrahtungslagen, daß die üblicherweise für die Isolation bzw. Abdeckung von Leitbahnen in der IC-Technik angewendeten Dielektrika (wie z.B. CVD-Oxide (= chemical vapor deposited $SiO_2$), PCVD-Oxid oder -Nitrid, Sputteroxide) ihre Anwendungsgrenzen als Zwischendielektrikum zeigen, da sich deutliche Mängel hinsichtlich der Technologie als auch hinsichtlich der Zuverlässigkeit der erhaltenen integrierten Schaltungen geltend machen.

Eine Alternative ist der Einsatz von Polyimiden oder anderen organischen Isoliermaterialien, die wie Photolack jeweils auf die letzte Metallisierungsebene aufgebracht und zu einer guten Einebnung der für die nächste Metallisierungsebene als Träger Oberseite führen. Eine sich an die Aufbringung einer solchen Polyimidschicht anschließende Temperaturbehandlung führt zu einer Vernetzung (Cyklisierung) und damit zu einer Stabilisierung dieser Schicht. Die enge Verwandschaft der Imide zu Photolacken bedeutet allerdings eine wesentliche Einschränkung bei weiteren Prozeßschritten, speziell bei der Strukturierung der nachfolgenden Leitbahnebenen. Zusätzlich ergibt sich eine geringere Haftfestigkeit der Metallisierung auf einer Polyimidunterlage, wie ein Vergleich mit der Haftfestigkeit der Metallisierung auf einer Unterlage aus Plasmanitrid zeigt.

Für die Erzeugung der zwischen den einzelnen Leitbahnebenen erforderlichen leitenden Verbindungen benötigten Kontaktlöchern in einer Isolierschicht aus Polyimid stehen spezifische Lösungsmittel zur Verfügung, welche beschränkt auf die Stelle des jeweils zu erzeugenden Kontaktloches angewendet werden könnten. Günstiger ist jedoch eine Trockenätzung, die z.B. mittels eines neutralen Ionenstrahles durchgeführt werden kann. Die Einwirkung des Ionenstrahles muß dann aufgrund einer geeigneten Maskierung auf die beabsichtigten Stellen der Polyimidschicht beschränkt werden. Hierzu dient eine maskierende Hilfsschicht aus einem anorganischen Material, die dann vor dem Aufbringen der Metallisierung wieder von der Oberfläche der Polyimidschicht wieder entfernt wird.

Es ist nun Aufgabe der Erfindung dafür zu sorgen, daß bei einem Verfahren der eingangs angegebenen Art einerseits eine gute Einebnung der von den die einzelnen Leitbahnebenen abzudeckenden Oberfläche der jeweils vorliegenden isolierenden Zwischenschicht und andererseits eine gute Haftfestigkeit der die einzelnen Leitbahnebenen bildenden Metallisierungen auf ihrer jeweiligen Unterlage gewährleistet ist.

Hierzu wird gemäß der Erfindung für das eingangs definierte Verfahren zum Herstellen einer monolithisch integrierten Schaltung vorgeschlagen, daß die aufgebrachte Metallisierung nach ihrer Strukturierung mit einer Polyimidschicht und letztere mit einer durch Plasmaentladung aufzubringenden anorganischen Isolierschicht abgedeckt und die anorganische Isolierschicht als Träger einer weiteren zu Leitbahnen zu verarbeitenden Metallisierung verwendet wird.

Bevorzugt besteht die auf den einzelnen Polyimidschichten (höchstens mit Ausnahme der letzten Polyimidschicht) jeweils durch Plasmaentladung aufzubringende anorganische Isolierschicht aus Siliciumnitrid, da dann die einzelnen Leitbahnen der auf ihr aufgebrachten Metallisierung in besonders hohem Maße stabil haften. Andererseits sichert die Anwendung einer Schicht aus Polyimid zwischen der jeweils unteren Metallisierung und der Siliciumnitrid - schicht, daß schon bei sehr geringen Schichtstärken der Polyimidschicht die auf ihr durch Plasmaentladung aufgebrachte anorganische Isolierschicht, insbesondere Siliciumnitridschicht, eine ebene Unterlage erhält. Damit wird vor allem der Einfluß von Überkreuzungsstellen von Leitbahnen , die übereinander angeordneten Metallisierungsebenen angehören und die leicht zu einem Abreißen der jeweils oberen Leitbahn führen, weitgehend ausgeschaltet. Die die jeweilige Polyimidschicht abdeckende anorganische Isolierschicht kann ggf. auch aus einem anderen Isoliermaterial, z.B. aus $SiO_2$, bestehen. Als Metall für die einzelnen Metallisierungsebenen ist vorzugsweise Aluminium vorgesehen, das z.B. durch Aufdampfen oder durch Aufsputtern aufgebracht wird.

Ebenso wie bei den üblichen Verfahren zur Herstellung von integrierten Halbleiterschaltungen mit Zweilagen- oder Mehrlagenverdrahtung ist auch im Falle der vorliegenden Erfindung eine Strukturierung der isolierenden Zwischenschicht erforderlich, die der Erzeugung der zwischen benachbarten Leitbahnebenen vorzusehenden leitenden Verbindungen dienenden Kontaktlöcher zu der darunterliegenden Leitbahnebene dient. Diese Kontaktlöcher werden dann bei der zum Zwecke der Herstellung der folgenden Leitbahnebene erforderlichen Metallisierung mit je einer - je einen Bestandteil einer aus der neuen Metallisierung zu formenden Leitbahn bildenden - Metallschicht ausgefüllt.

Im vorliegenden Fall handelt es sich bei der Herstellung der Kontaktlöcher in der jeweils die vorherige Metallisierung abdeckenden Isolierschicht sowohl um eine Strukturierung der den unteren Teil dieser Isolierschicht bildenden Polyimidschicht als auch um eine Strukturierung der die Polyimidschicht abdeckenden anorganischen Isolierschicht, wobei ersichtlich die Strukturierung der beiden Schichten in lateraler Beziehung identisch sein soll. Die Strukturierung der Polyimidschicht zur Erzeugung der Kontaktlöcher kann, wie bereits angedeutet, entweder naßchemisch (d.h. unter Verwendung eines flüssigen Lösungsmittels für das Polyimid, wie z.B. einen Photolackentwickler oder Kalilauge) oder durch Plasmaentladung erfolgen. Hierzu wird zweckmäßig zunächst die ganzflächig aufgebrachte anorganische Isolierschicht mit einer die zu erzeugende Struktur bedingenden Photolackmaske abgedeckt und dann zuerst die gewünschte Strukturierung zunächst in der anorganischen Isolierschicht und dann in der darunter liegenden Polyimidschicht erzeugt.

Arbeitet man mit einem naßchemischen Verfahren, so dient zweckmäßig die zunächst strukturierte anorganische Isolierschicht dann als Ätzmaske für die Strukturierung der Polyimidschicht, da diese in vielen Fällen (z.B. bei der Verwendung von Siliciumnitrid als Material für die anorganische Isolierschicht) gegen die für die Strukturierung der Polyimidschicht anzuwendenden Lösungsmittel stabil ist. Andererseits dient bei einer gleichzeitigen Strukturierung der anorganischen Isolierschicht und der darunter befindlichen Polyimidschicht durch Plasmaätzen die die anorganische Isolierschicht abdeckende Maske ohne Abänderung als Strukturierungsmaske für die Polyimidschicht.

Das erfindungsgemäße Verfahren läuft z.B. folgendermaßen ab:
a) auf die untere Leitbahn wird ein Sandwich aus Polyimid (z.B. mit einer Sträke von 1,5 µm) und Plasmanitrid (mit einer Stärke von 0,15 µm) aufgebracht;
b) die Plasmanitridschicht wird durch herkömmliche Verfahren zur Erzeugung der Kontaktlöcherstruktur behandelt;
c) die strukturierte Plasmanitridschicht dient als Ätzmaske für die Strukturierung der Polyimidschicht sowie als Träger für die Metallisierung der oberen Leitbahnebene.

Bei der Strukturierung der Polyimidschicht ist eine Unterätzung der Plasmanitridmaske zu vermeiden. Dies ist durch Anwendung eines anisotropen Ätzverfahrens, wie Ionenstrahlätzen oder RIE zu erreichen.

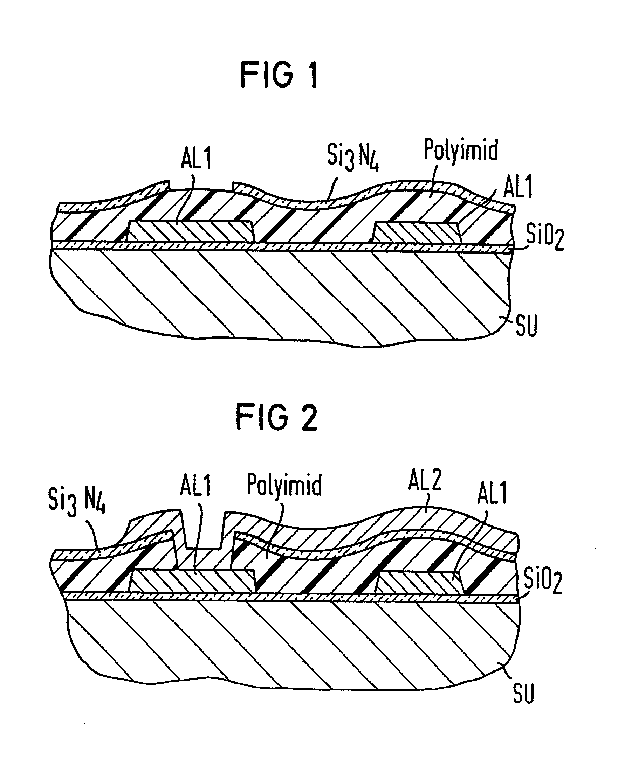

Die Durchführung des erfindungsgemäßen Verfahrens wird nochmals anhand der Figuren 1 und 2 beschrieben.

Nachdem die Dotierungsstruktur der integrierten Schaltung im Inneren des - vorzugsweise aus monokristallinem Silicium bestehenden - Substrats SU unter Verwendung einer $SiO_2$-Schicht als Dotierungsmaske in üblicher Weise hergestellt ist, wird auf die als Isolierung an der Oberfläche des Substrats SU verbleibende $SiO_2$-Schicht eine insbesondere aus Aluminium bestehende Metallisierung aufgebracht, die über Kontaktlöcher in der $SiO_2$-Schicht

die erforderlichen Verbindungen zu der Substratoberfläche automatisch erhält. Durch entsprechende Ätzung der die Grundlage der ersten Leitbahnebene bildenden Metallisierung erhält man die Leitbahnen AL1 der ersten Metallisierungsbene.

Gemäß der Erfindung wird nun die mit den Leitbahnen (bzw. mit die Halbleiteroberfläche kapazitiv steuernden Elektroden) der ersten Metallisierungsebene bedeckte $SiO_2$-Schicht gesamtflächig mit einer etwa 1,5 µm starken Schicht aus Polyimid bedeckt, was in der für das Aufbringen von Photolackschichten üblichen Weise geschehen kann. Schließlich wird die aufgebrachte unstrukturierte Polyimidschicht mit einer durch Plasmaentladung in einem geeigneten Reaktionsgas (z.B. einem Gemisch aus $NH_3$, $SiH_4$ und Ar oder $H_2$) erhaltenen Siliciumnitridschicht $Si_3N_4$ abgedeckt, die zweckmäßig auf eine Stärke von 0,15 µm bemessen wird.

Unter Verwendung einer Photolack-Ätztechnik wird dann, z.B. unter Anwendung von Plasmaätztechnik, die Nitridschicht $Si_3N_4$ an den von der Photolackmaske unbedeckten Stellen von der Oberfläche der Polyimidschicht lokal entfernt, so daß der aus Figur 1 ersichtliche Zustand erreicht ist. Nunmehr wird unter Verwendung der $Si_3N_4$-Schicht als Ätzmaske auch die Polyimidschicht an den von der $Si_3N_4$-Schicht unbedeckten und zu den beabsichtigten Kontaktstellen der Leitbahnen AL1 der ersten Metallisierungsebene führenden Stellen entfernt, so daß an den beabsichtigten Kontaktierungsstellen der ersten Metallisierungsebene beim Aufbringen der die Grundlage der zweiten Leitbahnebene bildenden Metallisierung automatisch die gewünschten Verbindungen zu den Kontaktstellen der ersten Metallisierungsebene entstehen. Auch die Metallisierung für die zweite Leitbahnebene wird in üblicher Weise, z.B. durch Aufsputtern oder Aufdampfen von Aluminium oder einem anderen geeigneten Kontaktierungsmetall, erzeugt und dann in bekannter Weise, z.B. unter Anwendung der Photolack-Ätztechnik struturiert, so daß die Leitbahnen AL2 der zweiten Leitbahnebene entstehen. Der damit erreichte Zustand ist in Figur 2 dargestellt.

Will man die in Figur 2 dargestellte Anordnung mit einer dritten Metallisierungsebene versehen, so wird die Nitridschicht samt den von ihr getragenen Leitbahnen AL2 ganzflächig mit einer weiteren Polyimidschicht und letztere mit einer weiteren Plasma-$Si_3N_4$-Schicht abgedeckt und letztere als Träger für die dritte Leitbahnebene verwendet. Es ist ohne weiteres verständlich, daß man das erfindungsgemäße Verfahren auch für die Herstellung einer vierten Leitbahnebene usw. anwenden kann.

Zusammenfassend ist hinsichtlich der Vorteile des erfindungsgemäßen Verfahrens festzustellen, daß diese Vorteile insbesondere darin liegen, daß

1.) auch die Leitbahnen der zweiten, dritten usw. Leitbahnebene auf einer anorganischen Unterlage aufgebracht werden, so daß eine ausgezeichnete Haftung auch dieser Leitbahnen gesichert ist;

2.) daß dem extrem restgasabhängigen Sputterprozeß auch bei der Metallisierung für die zweite Leitbahnebene sowie weiterer ggf. vorgesehener Leitbahnebenen eine saubere anorganische Unterlage angeboten wird;

3.) daß die Vorteile eines organischen Dielektrikums für die Zwischenschicht zwischen den benachbarten Leitbahnebenen mit den Vorteilen einer anorganischen Isolierschicht als Zwischendielektrikum vereinigt werden.

2 Figuren

5 Patentansprüche

Patentansprüche

1.) Verfahren zum Herstellen einer monolithisch integrierten Schaltung, bei dem die Oberfläche des zur Aufnahme der pn-Übergänge der integrierten Schaltung dienenden und vorzugsweise aus monokristallinem Silicium bestehenden Halbleitersubstrats mit einer $SiO_2$-Schicht versehen und letztere als Träger für eine durch Leitbahnen bzw. durch kapazitiv mit der Oberfläche des Halbleitersubstrats unter Vermittlung der $SiO_2$-Schicht gekoppelten Elektroden gegebene erste Metallisierung verwendet wird, bei dem nach Herstellung der ersten Metallisierung diese mit Isolierschichten abgedeckt und diese Isolierschichten nach deren Strukturierung als Träger für eine weitere zu Leitbahnen zu verarbeitende Metallisierung verwendet werden, dadurch gekennzeichnet, daß die aufgebrachte erste Metallisierung (AL1) nach ihrer Strukturierung mit einer Polyimidschicht und letztere mit einer durch Plasmaentladung aufzubringenden anorganischen Isolierschicht abgedeckt und die anorganische Isolierschicht als Träger einer weiteren zu Leitbahnen zu verarbeitenden Metallisierung verwendet wird.

2.) Verfahren nach Anspruch 1, dadurch gekennzeichnet, daß als Material für die anorganische Isolierschicht Siliciumnitrid verwendet wird.

3.) Verfahren nach Anspruch 1 oder 2, dadurch gekennzeichnet, daß die Polyimidschicht auf eine Stärke von 1,5 µm und anorganische Isolierschicht auf eine Stärke von 0,15 - 0,30 µm eingestellt wird.

4.) Verfahren nach einem der Ansprüche 1 bis 3, dadurch gekennzeichnet, daß die Strukturierung wenigstens einer der beiden Isolierschichten unter Anwendung des Plasmaätzens erzeugt wird.

5.) Verfahren nach einem der Ansprüche 1 bis 4, <u>dadurch</u>
<u>gekennzeichnet</u>, daß die Strukturierung der Polyimidschicht derart durchgeführt wird, daß keine Unterätzung
der sie bedeckenden anorganischen Isolierschicht stattfindet.

## FIG 1

AL1    Si₃N₄    Polyimid    AL1    SiO₂    SU

## FIG 2

Si₃N₄    AL1    Polyimid    AL2    AL1    SiO₂    SU

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. ³) |
|---|---|---|---|
| X | EP-A-0 046 525  (IBM)<br>* Ansprüche 1-3, 5, 6; Seite 10, Zeilen 8-25; Seite 12, Zeilen 4-14; Seite 13, Zeilen 11-24; Figuren 5, 8, 9, 13 * | 1-3,5 | H 01 L  21/90<br>H 01 L  23/52 |
| | --- | | |
| A | DE-A-3 026 026  (TOKYO SHIBAURA DENKI)<br>* Seiten 17, 18; Figur 11 * | 1 | |
| | --- | | |
| A | EP-A-0 019 391  (FUJITSU)<br>* Ansprüche 1, 5, 6; Seite 8, Zeile 21 - Seite 9, Zeile 2; Figuren 1A-1E * | 1 | |
| | --- | | |
| P,A | US-A-4 357 203  (RCA)<br><br>* Anspruch 1 * | | |
| | ----- | | |

**RECHERCHIERTE SACHGEBIETE (Int. Cl. ³)**

H 01 L  21/31
H 01 L  21/90
H 01 L  23/52

Der vorliegende Recherchenbericht wurde für alle Patentansprüche erstellt.

| Recherchenort<br>BERLIN | Abschlußdatum der Recherche<br>17-11-1983 | Prüfer<br>ROTHER A H J |
|---|---|---|